# EUROPÄISCHE PATENTSCHRIFT

(11) **EP 1 692 244 B1**
(45) Veröffentlichungstag und Bekanntmachung des Hinweises auf die Patenterteilung: **11.04.2007**
(21) Anmeldenummer: 04803620.6
(22) Anmeldetag: 08.12.2004
(51) Int. Cl.: C09K 11/06, H01L 51/30

(54) **VERWENDUNG VON PLATIN(II)-KOMPLEXEN ALS LUMINESZIERENDE MATERIALIEN IN ORGANISCHEN LICHT-EMITTIERENDEN DIODEN (OLEDS)**
USE OF PLATINUM II COMPLEXES AS LUMINESCENT MATERIALS IN ORGANIC LIGHT-EMITTING DIODES (OLEDS)
UTILISATION DE COMPLEXES DE PLATINE(II) COMME MATERIAUX LUMINESCENTS DANS DES DIODES ELECTROLUMINESCENTES ORGANIQUES

(30) Priorität: 12.12.2003 DE 10358665
(43) Veröffentlichungstag der Anmeldung: 23.08.2006
(73) Patentinhaber: BASF Aktiengesellschaft, 67056 Ludwigshafen (DE)
(72) Erfinder: LENNARTZ, Christian, 67105 Schifferstadt (DE); VOGLER, Arnd, 93051 Regensburg (DE); PAWLOWSKI, Valeri, 93053 Regensburg (DE)
(74) Vertreter: Isenbruck, Günter
(86) Internationale Anmeldenummer: PCT/EP2004/013944
(87) Internationale Veröffentlichungsnummer: WO 2005/056712

(56) Entgegenhaltungen:
- EP-A- 1 253 151
- US-A- 5 648 270
- US-A1- 2003 022 019
- US-A1- 2003 205 707
- KUNKLEY H., VOGLER A.: J. AM. CHEM. SOC., Bd. 112, 1990, Seiten 5625-5627, XP002325154 in der Anmeldung erwähnt
- CHE. C.-M. ET AL.: J. CHEM. SOC., CHEM. COMMUN., Bd. 14, 1989, Seiten 943-944, XP002325155 in der Anmeldung erwähnt

## Beschreibung

Die vorliegende Erfindung betrifft die Verwendung von Platin(II)-Komplexen als Emittermolkeküle in organischen Leuchtdioden (OLEDs), die Verwendung der Platin(II)-Komplexe als Licht-emittierende Schicht in OLEDs, eine Licht-emittierende Schicht enthaltend mindestens einen Platin(II)-Komplex, ein OLED enthaltend diese Licht-emittierende Schicht sowie Vorrichtungen, die ein erfindungsgemäßes OLED enthalten.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigeren Stromverbrauchs eignen sich Vorrichtungen, enthaltend OLEDs insbesondere für mobile Anwendungen, zum Beispiel für Anwendungen in Handys, Laptops usw.

Es wurden zahlreiche Materialien vorgeschlagen, die bei der Anregung durch elektrischen Strom Licht emittieren.

WO 02/15645 betrifft OLEDs, die eine Licht-emittierende Schicht aufweisen, die phosphoreszierende Übergangsmetallverbindungen als Gastmaterialien (Dotierstoffe) enthält. Die Übergangsmetallverbindungen, unter anderem Platin-Acetylacetonato-Komplexe, zeigen Elektrophosphoreszenz.

WO 01/41512 betrifft OLEDs, die eine Licht-emittierende Schicht aufweisen, die ein Molekül der allgemeinen Formel L₂MX enthält, wobei M besonders bevorzugt Iridium ist und L ausgewählt ist aus der Gruppe bestehend aus 2-(1-Naphthyl)benzooxazol, 2-Phenylbenzooxazol, 2-Phenylbenzothiazol, 7,8-Benzochinolin, Cumaren, Thienylpyridin, Phenylpyridin, Benzothienylpyridin, 3-Methoxy-2-phenylpyridin und Tolylpyridin und X ausgewählt ist aus der Gruppe bestehend aus Acetylacetonat, Hexafluoracetylacetonat, Salicyliden, Picolinat und 8-Hydroxychinolinat. Gemäß der Beschreiung können die Moleküle der Formel L₂MX als Dotiermaterialien oder in Substanz in der Licht-emittierenden Schicht eingesetzt werden. In den Beispielen wird ein Molekül der Formel L₂MX (Bis(2-phenyl-benzothiazol)iridiumacetylacetonat ("BTIr")) jedoch lediglich als Dotierstoff eingesetzt.

WO 00/70655 betrifft elektrolumineszierende Schichten, die als Licht-emittierende Substanz eine phosphoreszierende organometallische Iridiumverbindung oder Osmiumverbindung aufweisen. Bevorzugt wird Tris(2-phenylpyridin)iridium (Ir(ppy)₃) als Licht-emittierende Verbindung eingesetzt. (Ir(ppy)₃) kann in Substanz oder als Dotierstoff, in 4,4'-N,N'-Dicarbazol-biphenyl (CBP) als Wirtsubstanz, eingesetzt werden. Gemäß den Beispielen (Beispiel 2) wird bei Einsatz von (Ir(ppy)₃) in Substanz eine starke Verminderung der Effizienz des OLEDs gegenüber einem Einsatz als Dotierstoff festgestellt.

Obwohl bereits Verbindungen bekannt sind, die im blauen, roten und grünen Bereich des elektromagnetischen Spektrums Elektrolumineszenz zeigen, ist die Bereitstellung von weiteren Verbindungen, die auch in Substanz als Licht-emittierende Schicht einsetzbar sind, wünschenswert. Unter Elektrolumineszenz ist sowohl Elektrofluoreszenz als auch Elektrophosphoreszenz zu verstehen.

Aufgabe der vorliegenden Anmeldung ist daher die Bereitstellung einer Verbindungsklasse, die zur Elektrolumineszenz im blauen, roten und grünen Bereich des elektromagnetischen Spektrums geeignet ist, wodurch die Herstellung von Vollfarbendisplays ermöglicht wird. Des Weiteren ist es Aufgabe der vorliegenden Anmeldung, Verbindungen bereitzustellen, die in Substanz, ohne Wirtsubstanzen, als Licht-emittierende Schicht in OLEDs eingesetzt werden können.

Diese Aufgabe wird durch die Verwendung von neutralen Platin(II)-Komplexen ausgewählt aus der Gruppe bestehend aus
Platin(II)-Phosphinkomplexen der Formel (I) 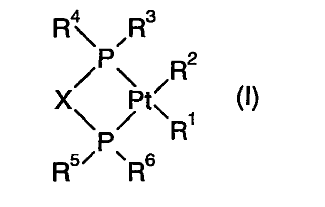 Platin(II)-Bathophen-Komplexen der Formel (II) 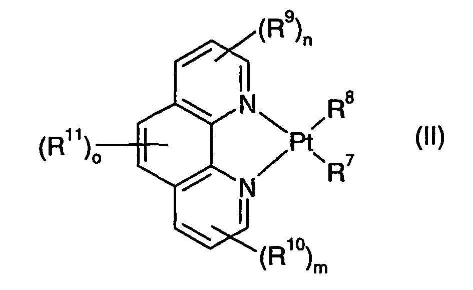 und
Platin(II)-bipyridyl-Komplexen der Formel (III) 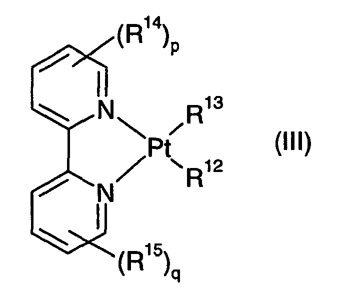 worin die Symbole die folgenden Bedeutungen aufweisen:
- R¹, R², R⁷, R⁸, R¹², R¹³: unabhängig voneinander CN, Acetylid, Thiocyanat oder Isocyanat, bevorzugt CN oder Acetylid, wobei sowohl Acetylide, die Alkylreste tragen, insbesondere t-Butylreste, als auch Acetylide, die aromatische Reste tragen, geeignet sind; besonders bevorzugt ist CN;
- R³, R⁴, R⁵, R⁶, R⁹, R¹⁰, R¹⁴, R¹⁵: unabhängig voneinander eine Aryl-, Alkyl-, Heteroaryl- oder Alkenylgruppe, bevorzugt eine Aryl- oder Alkylgruppe;
- X: eine Arylengruppe oder eine Heteroarylengruppe;
- o: 0 bis 2, bevorzugt 0;
- p, q: unabhängig voneinander 0 bis 4, bevorzugt 0 oder 1, besonders bevorzugt befinden sich die Gruppen R¹⁴ und R¹⁵ in 4- und 7-Position des Bipyridyl-Liganden, wenn p und q 1 bedeuten;
- n, m: unabhängig voneinander 0 bis 3, bevorzugt 0 oder 1, besonders bevorzugt befinden sich die Gruppen R⁹ und R¹⁰ in 4- und 7-Position des Bathophen-Liganden, wenn n und m 1 bedeuten,
wobei für den Fall, dass m, n, o, p bzw. q 0 sind, die entsprechenden Teile der Bathophen- bzw. Bipyridyl-Liganden Wasserstoffatome tragen, d.h. unsubstituiert sind, als Emittermoleküle in organischen Licht-emittierenden Dioden, gelöst.

Platin(II)-Komplexe sind im Stand der Technik bekannt. So ist in Vogler, J. Am. Chem. Soc. 1990, 112, 5625 bis 5627 des Komplexes Pt(Bathophen)(CN)₂ (Bathophen = 4,7-Diphenyl-1,10-phenanthrolin) offenbart. Bezüglich der Elektrolumineszenz dieses Pt-Komplexes werden keine Angaben gemacht.

Yam et al. Coordination Chemistry Reviews 229 (2002) 123 bis 132 betrifft Lumineszenzstudien von dinuklearen Platin(II)-Alkinyl-Komplexen und deren Gemischmetall Platin(II)-Kupfer(I) und Platin(II)-Silber(I)-Komplexen. Die untersuchten Platin(II)-Komplexe sind dinukleare Komplexe. Es wurde eine Rotverschiebung der dinuklearen Komplexe im Vergleich zu einem ebenfalls untersuchten mononuklearen Komplex, trans-[Pt(dppm-P)₂(C≡CR)₂], festgestellt.

In Crosby et al. Coordination Chemistry Reviews 171 (1998) 407 bis 417 werden die Charakteristiken von elektronisch angeregten Zuständen von Übergangsmetall-Komplexen untersucht. Die Untersuchung erfolgt an den Komplexen Pt(2,2'-bipyridin)(CN)₂ und Pt(2,2'-bipyridin)Cl₂, die in ihrer festen Form lineare Ketten bilden und an Pt(2-phenylpyridin)₂, das in diskreten dimeren Einheiten kristallisiert.

Che et al. Inorg. Chem. 2002, 41, 3866 bis 3875 betrifft Metall-Metallwechselwirkungen in dinuklearen d⁸-Metallcyanid-Komplexen, die Phosphinliganden aufweisen. Als Komplexe werden trans-[M₂(µ-diphosphin)₂(CN)₄] und trans-[M(phosphin)₂(CN)₂] untersucht, wobei M Pt oder Ni ist. Gemäß Tabelle 3, Seite 3871 ist der mononukleare Komplex [Pt(PCy₃)₂(CN)₂] in Dichlormethan nicht emittierend.

Keines der vorstehend genannten Dokumente betrifft die Elektrolumineszenz der darin offenbarten Komplexe, auf der der Einsatz von Verbindungen als Emittersubstanzen in OLEDs basiert.

Die Eignung von Platin(II)-Komplexen der Formeln I, II oder III gemäß der vorliegenden Erfindung als Licht-emittierende Substanzen in OLEDs, wobei die Substanzen dieses Strukturtyps gemäß Formel I, II oder III zur Elektrolumineszenz im roten, grünen und blauen Bereich des elektromagnetischen Spektrums geeignet sind, ist somit in keinem der vorstehend genannten Dokumente erwähnt.

Es wurde daher gefunden, dass die Platin(II)-Komplexe der Formeln I, II und III gemäß der vorliegenden Anmeldung als Licht-emittierende Substanzen in OLEDs zur Herstellung von Vollfarbendisplays geeignet sind.

Im Sinne der vorliegenden Anmeldung haben die Begriffe Arylrest oder -gruppe, Heteroarylrest oder -gruppe, Alkylrest oder -gruppe, Alkenylrest oder -gruppe, Arylenrest oder -gruppe und Heteroarylenrest oder -gruppe die folgenden Bedeutungen:

Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Alkylreste, bevorzugt Alkylreste mit 1 bis 8 Kohlenstoffatomen, besonders bevorzugt Methyl, Ethyl, i-Propyl oder t-Butyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I-und/oder -M-Effekt aufweisen. Geeignete Gruppen, mit Donor- oder Akzeptorwirkung sind Halogenreste, bevorzugt F, Cl, Br, besonders bevorzugt F, Alkoxyreste, Carbonylreste, Esterreste, Aminreste, Amidreste, CH₂F-Gruppen, CHF₂-Gruppen, CF₃-Gruppen, CN-Gruppen, Thiogruppen oder SCN-Gruppen. Ganz besonders bevorzugt tragen die Arylreste Substituenten ausgewählt aus der Gruppe bestehend aus Methyl, F, Cl und Alkoxy, oder die Arylreste sind unsubstituiert. Bevorzugt ist der Arylrest oder die Arylgruppe ein C₆-Arylrest, der gegebenenfalls mit mindestens einem der vorstehend genannten Substituenten substituiert ist. Besonders bevorzugt weist der C₆-Arylrest keinen, einen oder zwei der vorstehend genannten Substituenten auf, wobei der eine Substituent bevorzugt in para-Position zur weiteren Verknüpfungsstelle des Arylrestes angeordnet ist und - im Falle von zwei Substituenten - diese jeweils in meta-Position zur weiteren Verknüpfungsstelle des Arylrestes angeordnet sind. Ganz besonders bevorzugt ist der C₆-Arylrest ein unsubstituierter Phenylrest.

Unter einem Heteroarylrest oder einer Heteroarylgruppe sind Reste zu verstehen, die sich von den vorstehend genannten Arylresten dadurch unterscheiden, dass in dem Grundgerüst der Arylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Arylreste durch Heteroatome ersetzt. Insbesondere bevorzugt ist das Grundgerüst ausgewählt aus elektronenreichen Systemen wie Pyridyl, cyclischen Estern, cyclischen Amiden und fünfgliedrigen Heteroaromaten wie Pyrrol, Furane. Das Grundgerüst kann an einer, mehreren oder allen substituierbaren Positionen des Grundgerüsts substituiert sein. Geeignete Substituenten sind die selben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8 Kohlenstoffatomen zu verstehen. Dieser Alkylrest kann verzweigt oder unverzweigt sein und gegebenenfalls mit einem oder mehreren Heteroatomen, bevorzugt N, O oder S unterbrochen sein. Des Weiteren kann dieser Alkylrest mit einem oder mehreren der bezüglich der Arylgruppen genannten Substituenten substituiert sein. Es ist ebenfalls möglich, dass der Alkylrest eine oder mehrere Arylgruppen trägt. Dabei sind alle der vorstehend aufgeführten Arylgruppen geeignet. Besonders bevorzugt sind die Alkylreste ausgewählt aus der Gruppe bestehend aus Methyl, Ethyl, i-Propyl, n-Propyl, i-Butyl, n-Butyl, t-Butyl, sec-Butyl, i-Pentyl, n-Pentyl, sec-Pentyl, neo-Pentyl, n-Hexyl, i-Hexyl und sec-Hexyl. Ganz besonders bevorzugt sind Methyl, i-Propyl und n-Hexyl.

Unter einem Alkenylrest oder einer Alkenylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Doppelbindung ersetzt ist. Bevorzugt weist der Alkenylrest eine oder zwei Doppelbindungen auf.

Unter einer Arylengruppe bzw. einem Arylenrest ist eine Gruppe mit 6 bis 60 Kohlenstoffatomen, bevorzugt 6 bis 20 Kohlenstoffatomen zu verstehen. Geeignete Gruppen sind beispielsweise Phenylengruppen, bevorzugt Phenylengruppen, die in 1- und 2-Position mit jeweils einem der P-Atome gemäß Formel I verknüpft sind, Naphthalindiylgruppen, bevorzugt Naphthalindiylgruppen, die in 2- und 3-Position oder in 4- und 5-Position mit jeweils einem der beiden P-Atome der Formel I verknüpft sind, Anthracendiylgruppen, bevorzugt Anthracendiylgruppen, die in 2- und 3-Position oder 4- und 10-Position oder 4- und 5-Position mit jeweils einem der beiden P-Atome der Formel I verknüpft sind, Phenanthrendiylgruppen, bevorzugt Phenanthrendiylgruppen, die in der 2- und 3-Position oder in der 4- und 5-Position mit jeweils einem der beiden P-Atome der Formel I verknüpft sind, Biphenylengruppen, bevorzugt 1,1'-Biphenylen, besonders bevorzugt 1,1'-Biphenylengruppen, die in der 2- und 2'-Position mit jeweils einem der beiden P-Atome der Formel I verknüpft sind, Binaphthylengruppen, bevorzugt 1,1'-Binaphthylengruppen, besonders bevorzugt 1,1'-Binaphthylengruppen, die in der 2-und 2'-Position mit jeweils einem der beiden P-Atome der Formel I verknüpft sind, Xanthylengruppen, bevorzugt Xanthylengruppen, die in 4- und 5-Position mit jeweils einem der beiden P-Atome der Formel I verknüpft sind, besonders bevorzugt Xanthylengruppen, die in 9- und 9'-Position jeweils H oder eine Methylgruppe tragen, des Weiteren sind Triphenylengruppen, Stilbendiylgruppen, Distilbendiylgruppen sowie weitere Gruppen, die kondensierte Ringe, bevorzugt kondensierte 6-gliedrige Ringe, aufweisen, als Arylengruppen geeignet.

Die vorstehend genannten Arylengruppen oder -reste können unsubstituiert oder substituiert sein. Geeignete Substituenten sind zum Beispiel Alkylreste, bevorzugt Alkylreste mit 1 bis 8 Kohlenstoffatomen, besonders bevorzugt Methyl, Ethyl, i-Propyl oder t-Butyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Unter Gruppen mit Donorwirkung sind Gruppen zu verstehen, die einen +I-und/oder +M-Effekt aufweisen, und unter Gruppen mit Akzeptorwirkung sind Gruppen zu verstehen, die einen -I- und/oder -M-Effekt aufweisen. Geeignete Gruppen, mit Donor- oder Akzeptorwirkung sind Halogenreste, bevorzugt F, Cl, Br, besonders bevorzugt F, Alkoxyreste, Carbonylreste, Esterreste, Aminreste, Amidreste, CH₂F-Gruppen, CHF₂-Gruppen, CF₃-Gruppen, CN-Gruppen, Thiogruppen oder SCN-Gruppen. Ganz besonders bevorzugt tragen die Arylenreste Substituenten ausgewählt aus der Gruppe bestehend aus Methyl, F, Cl und Alkoxy. Die geeignete Anzahl möglicher Substituenten richtet sich nach der entsprechenden Verbindung und ist dem Fachmann bekannt. Bevorzugt sind die vorstehend genannten Verbindungen unsubstituiert oder weisen einen oder zwei Substituenten auf. Ganz besonders bevorzugt sind die vorstehend genannten Verbindungen unsubstituiert. Bevorzugte Arylengruppen oder -reste sind ausgewählt aus der Gruppe bestehend aus Phenylengruppen, die in 1- und 2-Position mit jeweils einem der P-Atome gemäß Formel I verknüpft sind, und besonders bevorzugt unsubstituiert sind, Naphthalindiylgruppen, die in 2- und 3-Position oder in 4- und 5-Position mit jeweils einem der P-Atome gemäß Formel I verknüpft sind, und besonders bevorzugt unsubstituiert sind, und 1,1'-Binaphthylengruppen, die in der 2- und 2'-Position mit jeweils einem der P-Atome der Formel I verknüpft sind, und besonders bevorzugt unsubstituiert sind.

Geeignete Heteroarylengruppen sind solche, in denen mindestens eine CH-Einheit der vorstehend genannten Verbindungen durch eine Einheit enthaltend ein Heteroatom, bevorzugt ausgewählt aus Sauerstoff, Schwefel, Stickstoff, Phosphor und Bor, besonders bevorzugt Sauerstoff, Schwefel und Stickstoff, ganz besonders bevorzugt Stickstoff, ersetzt ist. Bevorzugt sind ein oder zwei CH-Gruppen der vorstehend genannten Verbindungen durch eines der vorstehend genannten Heteroatome ersetzt.

Geeignete Heteroarylengruppen, die Stickstoff als Heteroatom aufweisen, sind Pyridindiylgruppen, Diazaphenylengruppen, Chinolindiylgruppen, Chinoxalindiylgruppen, Aziridindiylgruppen, Bipyridylgruppen, Phenanthrolindiylgruppen, wobei jeweils eine Verknüpfung mit jeweils einem der beiden P-Atome der Formel I möglich ist. Geeignete Gruppen, die andere Heteroatome außer Stickstoffatomen enthalten, sind dem Fachmann bekannt. Die Heteroarylengruppen können unsubstituiert oder substituiert sein, wobei die Zahl der Substituenten von der jeweiligen Heteroarylengruppe abhängig ist. Geeignete Substituenten sind die selben, die bereits vorstehend bezüglich der Arylenreste genannt sind. In einer Ausführungsform sind die Heteroarylengruppen unsubstituiert oder tragen einen oder zwei Substituenten, ganz besonders bevorzugt sind die Heteroarylengruppen unsubstituiert.

Bevorzugte Platin(II)-Komplexe der Formel I sind solche, in denen R¹ und R² CN oder Acetylid, besonders bevorzugt CN bedeuten und R³, R⁴, R⁵ und R⁶ einen Arylrest, bevorzugt einen Phenylrest, der wie vorstehend genannt substituiert oder unsubstituiert sein kann, besonders bevorzugt einen unsubstituierten Phenylrest bedeuten, und X ausgewählt ist aus der Gruppe bestehend aus einer Phenyengruppe, die in der 1- und 2-Position mit jeweils einem der beiden P-Atome der Formel I verknüpft ist, und besonders bevorzugt unsubstituiert ist, einer Napthalindiylgruppe, die in 2- und 3-Position oder 4- und 5-Position mit jeweils einem der beiden P-Atome der Formel I verknüpft ist, wobei die Naphthalindiylgruppe besonders bevorzugt unsubstituiert ist, einer Phenanthrendiylgruppe, die in 2- und 3-Position oder in 4- und 5-Position mit jeweils einem der beiden P-Atome der Formel I verknüpft ist, wobei die Phenanthrenylengruppe besonders bevorzugt unsubstituiert ist, einer 1,1'-Biphenylengruppe, die in der 2- und 2'-Position mit jeweils einem der beiden P-Atome der Formel I verknüpft ist, wobei die Biphenylengruppe besonders bevorzugt unsubstituiert ist, und einer 1,1'-Binapthylengruppe, die in der 2- und 2'-Position mit jeweils einem der beiden P-Atome der Formel I verknüpft ist, wobei die Binaphtyhlengruppe besonders bevorzugt unsubstituiert ist. Besonders bevorzugt ist X ausgewählt aus einer unsubstituierten Phenylengruppe, die in 1- und 2-Position mit jeweils einem der beiden P-Atome der Formel I verknüpft ist, und einer 1,1'-Binaphthylengruppe, die in der 2- und 2'-Position mit jeweils einem der beiden P-Atome der Formel I verknüpft ist, und unsubstituiert ist.

Bevorzugte Platin(II)-Bathophenkomplexe der Formel II sind solche, worin R⁷ und R⁸ Acetylid oder CN, besonders bevorzugt CN, bedeuten und m, n und o 0 oder 1 bedeuten, wobei, wenn o = 0 bedeutet, die Bathophen-Gruppe unsubstituiert ist und, wenn m, n und o unabhängig voneinander 1 bedeuten, die Bathophengruppe mit den bereits vorstehend erwähnten Substituenten substituiert ist, wobei die Substituenten R⁹, R¹⁰ und R¹¹ der Bathophen-Gruppe der Formel (II) besonders bevorzugt unsubstituiertes Phenyl bedeuten. Ganz besonders bevorzugt sind m, n und o = 0 oder o ist 0 und m und n sind 1, wobei R⁹ und R¹⁰ ganz besonders bevorzugt unsubstituiertes Phenyl bedeuten. Insbesondere bevorzugt befinden sich die Substituenten R⁹ und R¹⁰ in der 4-und 7-Position des Bathophenrestes, wenn m und n 1 bedeuten.

Bei dem Platin(II)-Bipyridyl-Komplex der Formel III handelt es sich bevorzugt um einen Komplex, worin R¹² und R¹³ Acetylid oder CN, bevorzugt CN, bedeuten und p und q 0 oder 1 bedeuten, wobei bevorzugt entweder sowohl p als auch q 0 bedeuten oder sowohl p als auch q 1 bedeuten. Für den Fall, dass p bzw. q 1 bedeuten, sind R¹⁴ und R¹⁵ Substituenten wie vorstehend definiert. Ganz besonders bevorzugt sind R¹⁴ und R¹⁵ tert-Butyl. Insbesondere bevorzugt befinden sich die Substituenten R¹⁴ und R¹⁵ für den Fall, dass p und q = 1 bedeuten in 4- und 7-Position des Bipyridylrests.

Ein weiterer Gegenstand der vorliegenden Anmeldung ist die Verwendung von Pt(II)-Komplexen der Formeln II oder III, worin in den Platin(II)-Komplexen der Formel II und den Platin(II)-Komplexen der Formel III R⁷, R⁸, R¹² und R¹³ CN, m, n, p, q 0 oder 1 und o 0 bedeuten, und - wenn m, n = 1 bedeuten- R⁹ und R¹⁰ unsubstituiertes Phenyl bedeuten und - wenn p, q 1 bedeuten - R¹⁴ und R¹⁵ tert-Bu bedeuten.

Ganz besonders bevorzugte Verbindungen der Formeln I, II und III sind die im Folgenden aufgeführten Formeln

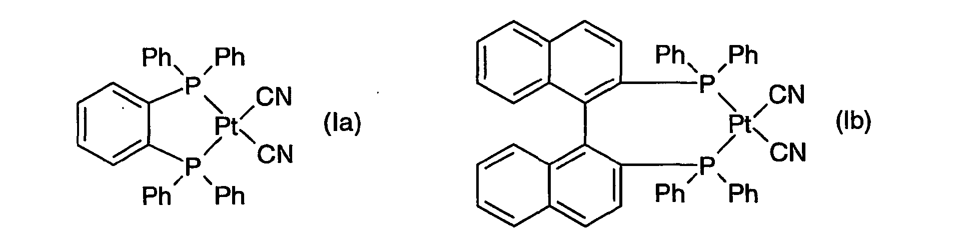

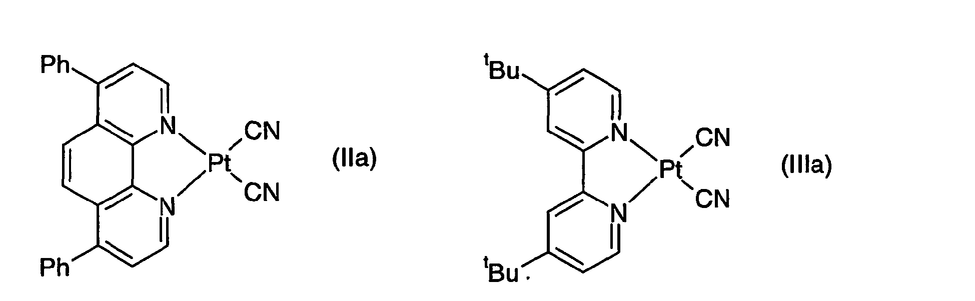

Die vorstehend genannten neutralen Übergangsmetall-Komplexe sind hervorragend als Emittermoleküle in organischen Licht-emittierenden Dioden (OLEDs) geeignet. Durch einfache Variationen der Liganden ist es möglich, Übergangsmetall-Komplexe bereit zu stellen, die Elektrolumineszenz im roten, grünen sowie insbesondere im blauen Bereich des elektromagnetischen Spektrums zeigen. Die erfindungsgemäß verwendeten neutralen Übergangsmetall-Komplexe eignen sich daher für den Einsatz in technisch verwendbaren Vollfarbendisplays.

Die Herstellung der Platin(II)-Komplexe erfolgt nach dem Fachmann bekannten Verfahren.

Übliche Verfahren sind zum Beispiel die Deprotonierung von den den Liganden der Verbindungen der Formeln I, II und III entsprechenden Ligandvorläufern und anschließende, im Allgemeinen in situ, Umsetzung mit geeigneten Pt enthaltenden Metallkomplexen. Des Weiteren ist die Herstellung der Platin(II)-Komplexe der Formeln I, II, und III durch direkte Umsetzung der neutralen, den Liganden der Platin(II)-Komplexe entsprechenden Ligandvorläufer mit den geeigneten Platin(II)-Komplexen möglich, was bevorzugt ist.

Geeignete Ligandvorläufer, die zu den Liganden der Platin(II)-Komplexe der Formeln I, II und III führen, sind dem Fachmann bekannt.

Erfolgt eine Deprotonierung der Liganden, so kann diese durch basische Metallate, basische Anionen wie Metallacetate, Acetylacetonate oder Alkoxylate oder externe Basen wie KO^{t}Bu, NaO^{t}Bu, LiO^{t}Bu, NaH, Silylamide sowie Phosphazenbasen erfolgen.

Geeignete als Ausgangsverbindung einsetzbare Platinkomplexe sind dem Fachmann bekannt und enthalten bevorzugt Reste der Gruppen R¹ und R², bzw. R⁷ und R⁸ bzw. R¹² und R¹³. Somit sind bevorzugte Platinkomplexe Platin-Acetylidkomplexe und Platin-Cyanidkomplexe wie Pt(CN)₂. Die Platin-Acetylidkomplexe können z.B. durch Umsetzung des entsprechenden Platin-Chloridkomplex, z.B. [Pt(dppm)₂]Cl₂ mit einem Acetylid, z.B. Li-Acetylid oder Quecksilberacetylid erhalten werden. Geeignete Verfahren zur Herstellung von Platin-Acetyliden sind in Yam et al. Coordination Chemistry Reviews 229 (2002) 123-132 und der darin zitierten Literatur offenbart.

Die Umsetzung erfolgt bevorzugt in einem Lösungsmittel. Geeignete Lösungsmittel sind dem Fachmann bekannt und sind bevorzugt ausgewählt aus aromatischen, aliphatischen Lösungsmitteln, Ethern, Alkoholen, und polaren aprotischen Lösungsmitteln. Besonders geeignete polare aprotische Lösungsmittel sind Dimethylformamid und Dimethylacetamid.

Das molare Verhältnis von eingesetztem Platinkomplex zu eingesetztem Ligandvorläufer beträgt bevorzugt 0,7 : 1,0 bis 1,5 : 1,0, besonders bevorzugt 0,9 : 1,0 bis 1,1 : 1, ganz besonders bevorzugt 1 : 1.

Bevorzugt werden die Platin(II)komplexe der Formeln I, II und III, durch direkte Umsetzung des entsprechenden Ligandvorläufers mit einem Platinkomplex erhalten. Diese Umsetzung erfolgt besonders bevorzugt in einem polaren aprotischen Lösungsmittel in den bereits vorstehend angegebenen molaren Verhältnissen von Platinkomplexen und eingesetzten Ligandvorläufem.

Die Umsetzung erfolgt im Allgemeinen bei Temperaturen von 20 bis 200 °C, bevorzugt 70 bis 180 °C, besonders bevorzugt bei dem Siedepunkt des eingesetzten Lösungsmittels.

Die Reaktionsdauer ist abhängig von dem gewünschten Platin(II)-Komplex und beträgt im Allgemeinen von 1 h bis 50 h, bevorzugt 2 h bis 30 h, besonders bevorzugt 5 h bis 25 h.

Der erhaltene Platin(II)-Komplex der Formeln I, II, bzw. III wird nach dem Fachmann bekannten Methoden aufgearbeitet. Beispielsweise wird das während der Umsetzung ausgefallene Produkt filtriert, gewaschen, zum Beispiel mit Ether, insbesondere Diethylether, und anschließend getrocknet. Durch Umkristallisation, zum Beispiel aus Dichlormethan/Diethylether oder Dichlorethan/Diethylether, werden hochreine Platin(II)-Komplexe erhalten.

Die erfindungsgemäß verwendeten Platin(II)-Komplexe der Formeln (I), (II) oder (III) eignen sich hervorragend als Emittersubstanzen, da sie eine Emission (Elektrolumineszenz) im sichtbaren Bereich des elektromagnetischen Spektrums aufweisen. Mit Hilfe der erfindungsgemäß verwendeten Platin(II)-Komplexe als Emittersubstanzen ist es möglich, Verbindungen bereit zu stellen, die Elektrolumineszenz im roten, grünen sowie im blauen Bereich des elektromagnetischen Spektrums aufweisen. Somit ist es möglich mit Hilfe der erfindungsgemäß verwendeten Platin(II)-Komplexe als Emittersubstanzen technisch einsetzbare Vollfarbendisplays bereit zu stellen.

Bei den Platin(II)-Komplexen, insbesondere bei den Platin(II)-Komplexen der Formel I, handelt es sich bevorzugt um einkernige Komplexe. Diese sind bevorzugt nicht nur in Lösung einkemig, sondern auch im Festkörper. Ein weiterer Gegenstand der vorliegenden Anmeldung betrifft daher die Verwendung der Platin(II)-Komplexe gemäß den Formeln I, II, und III, wobei Platin(II)-Komplexe der Formel I besonders bevorzugt sind, wobei die Komplexe einkernige Komplexe sind. Besonders bevorzugte einkernige Komplexe sind die als besonders bevorzugt bezeichneten Platin(II)-Komplexe, die bereits vorstehend erwähnt wurden.

Eine besondere Eigenschaft der Platin(11)-Komplexe der Formeln I, II und III ist, dass diese im Festkörper Lumineszenz, besonders bevorzugt Elektrolumineszenz, im sichtbaren Bereich des elektromagnetischen Spektrums zeigen. Diese im Festkörper lumineszierenden Komplexe können in Substanz, also ohne weitere Zusätze, als Emittersubstanzen in OLEDs eingesetzt werden. Dadurch kann ein OLED mit einer Licht-emittierenden Schicht hergestellt werden, wobei keine aufwendige Coverdampfung eines Matrixmaterials mit der Emittersubstanz erforderlich ist. Einkernige Platin(II)-Komplexe, die im Festkörper Lumineszenz, insbesondere Elektrolumineszenz, zeigen sind aus dem Stand der Technik nicht bekannt.

Ein weiterer Gegenstand der vorliegenden Anmeldung ist daher die Verwendung von Platin(II)-Komplexen der Formeln I, II und III, besonders bevorzugt von Platin(II)-Komplexen der Formel I, als Licht-emittierende Schicht in OLEDs.

Organische Licht-emittierende Dioden sind grundsätzlich aus mehreren Schichten aufgebaut:
1. Anode
2. Löcher-transportierende Schicht
3. Licht-emittierende Schicht
4. Elektronen-transportierende Schicht ,
5. Kathode

Die Platin(II)-Komplexe der Formeln I, II, und III, bevorzugt die Komplexe der Formel I, werden bevorzugt in der Licht-emittierenden Schicht als Emittermoleküle eingesetzt. Ein weiterer Gegenstand der vorliegenden Anmeldung ist daher eine Licht-emittierende Schicht enthaltend mindestens einen Platin(II)-Komplex der Formeln I, II und/oder III, bevorzugt mindestens einen Komplex der Formel I, als Emittermolekül. Bevorzugte Platin(II)-Komplexe der Formeln I, II und III, insbesondere Platin(II)-Komplexe der Formel I, sind bereits vorstehend genannt.

Die erfindungsgemäß verwendeten Platin(II)-Komplexe der Formeln I, II und III können in Substanz - ohne weitere Zusätze - in der Licht-emittierenden Schicht vorliegen. Es ist jedoch ebenfalls möglich, dass neben den erfindungsgemäß eingesetzten Platin(II)-Komplexen der Formeln I, II oder III weitere Verbindungen in der Licht-emittierenden Schicht vorliegen. Beispielsweise kann ein fluoreszierender Farbstoff anwesend sein, um die Emissionsfarbe des als Emittermoleküls eingesetzten Platin(II)-Komplexes zu verändern. Des Weiteren kann ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N,N'-Dicarbazolbiphenyl (CDP) oder tertiäre aromatische Amine. Wenn ein Verdünnungsmaterial eingesetzt wird, beträgt der Anteil der erfindungsgemäß eingesetzten Platin(II)-Komplexe in der Licht-emittierenden Schicht im Allgemeinen weniger als 20 Gew.-%, bevorzugt 3 bis 10 Gew.%. Bevorzugt werden die Platin(II)-Komplexe der Formeln I, II und III in Substanz eingesetzt, wodurch eine aufwendige Coverdampfung der Platin(II)-Komplexe mit einem Matrixmaterial (Verdünnungsmaterial oder fluoreszierender Farbstoff) vermieden wird. Dafür ist es wesentlich, dass die Platin(II)-Komplexe im Festkörper lumineszieren. Die Platin(II)-Komplexe der Formeln I, II und III zeigen im Festkörper Lumineszenz. Somit enthält die Licht-emittierende Schicht bevorzugt mindestens einen Platin(II)-Komplex der Formel I, 11 oder III, bevorzugt einen Platin(II)-Komplex der Formel I und kein Matrixmaterial ausgewählt aus Verdünnungsmaterial und fluoreszierendern Farbstoff.

Ein weiterer Gegenstand der vorliegenden Anmeldung ist in einer bevorzugten Ausführungsform eine Licht-emittierende Schicht bestehend aus mindestens einem Platin(II)-Komplex der Formeln I, II und/oder III, bevorzugt bestehend aus mindestens einem Komplex der Formel I, als Emittermolekül. Bevorzugte Komplexe der Formeln I, II und III wurden bereits vorstehend genannt.

Die einzelnen der vorstehend genannten Schichten des OLEDs können wiederum aus 2 oder mehreren Schichten aufgebaut sein. Beispielsweise kann die Löcher-transportierende Schicht aus einer Schicht aufgebaut sein in die aus der Elektrode Löcher injiziert werden und einer Schicht, die die Löcher von der Loch injizierenden Schicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektronen-injizierenden Schicht Elektronen erhält und in die Licht-emittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß als Emittersubstanzen verwendeten Platin(II)-Komplexe angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist ein OLED enthaltend mindestens eine erfindungsgemäße Licht-emittierende Schicht. Die weiteren Schichten in dem OLED können aus einem beliebigen Material aufgebaut sein, das üblicherweise in solchen Schichten eingesetzt wird und dem Fachmann bekannt ist.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (α-NPD), N, N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N, N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB) und Porphyrinverbindungen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronen transportierende Materialien für die Schicht (4) der erfindungsgemäßen OLEDs umfassen mit oxinoiden Verbindungen chelatisierte Metalle wie Tris(8-hydroxychinolato)aluminium (Alq₃), Verbindungen auf Phenanthrolinbasis wie 2,9-Dimethyl, 4,7-Diphenyl-1, 10-phenanthrolin (DDPA) oder 4,7-Diphenyl-1,10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons.
Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:
- eine Loch-Injektionsschicht zwischen der Anode (1) und der Löcher-transportierenden Schicht (2);
- eine Blockschicht für Elektronen zwischen der Löcher-transportierenden Schicht (2) und der Licht-emittierenden Schicht (3);
- eine Blockschicht für Löcher zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Dem Fachmann ist bekannt, wie er (zum Beispiel auf Basis von elektrochemischen Untersuchungen) geeignete Materialien auswählen muss. Geeignete Materialien für die einzelnen Schichten sind dem Fachmann bekannt und z.B. in WO 00/70655 offenbart.

Des Weiteren kann jede der genannten Schichten des erfindungsgemäßen OLEDs aus zwei oder mehreren Schichten ausgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des erfindungsgemäßen OLEDs kann nach dem Fachmann bekannten Methoden erfolgen. Im Allgemeinen wird das OLED durch aufeinanderfolgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden.

Im Allgemeinen haben die verschiedenen Schichten folgende Dicken: Anode (2) 500 bis 5000 Å, bevorzugt 1000 bis 2000 Å; Löcher-transportierende Schicht (3) 50 bis 1000 Ä, bevorzugt 200 bis 800 Å, Licht-emittierende Schicht (4) 10 bis 1000 Å, bevorzugt 100 bis 800 Å, Elektronen transportierende Schicht (5) 50 bis 1000 Å, bevorzugt 200 bis 800 Å, Kathode (6) 200 bis 10.000 Å, bevorzugt 300 bis 5000 Å. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz des erfindungsgemäß verwendeten Platin(II)-Komplexe der Formeln I, II oder III als Emittermolekül in der Licht-emittierenden Schicht der erfindungsgemäßen OLEDs können OLEDs mit hoher Effizienz erhalten werden. Die Effizienz der erfindungsgemäßen OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Fahrzeugen sowie Zielanzeigen an Bussen und Bahnen.

Weiterhin können die erfindungsgemäß eingesetzten Platin(II)-Komplexe der Formeln I, II oder III in OLEDs mit inverser Struktur eingesetzt werden. Bevorzugt werden die Platin(II)-Komplexe in diesen inversen OLEDs wiederum in der Licht-emittierenden Schicht, besonders bevorzugt als Licht-emittierende Schicht ohne weitere Zusätze, eingesetzt. Der Aufbau von inversen OLEDs und die üblicherweise darin eingesetzten Materialien sind dem Fachmann bekannt.

### Beispiele

### 1. Herstellung von Platin(II)-Komplexen

### Allgemeines

Alle Lösungsmittel, die für spektrometrische Messungen verwendet werden, haben die entsprechende für spektrometrische Messungen geeignete Qualität. Pt(CN)₂, dppb (1,2-bis(Diphenylphosphino)benzol) und binap (1,1'-Binaphthyl) sowie Bathophen (4,7-Diphenyl-1,10-phenanthrolin) und tert-Bu₂bpy (4,4'-tert-Butyl-2,2'-bipyridin) sind kommerziell erhältlich und werden ohne weitere Reinigung eingesetzt.

### a) [Pt(dppb)(CN)₂]

Eine Mischung aus Pt(CN)₂ (0,76 g, 3 mmol) und dppb (1,38 g, 3 mmol) werden in 70 ml Dimethylformamid gelöst und für 6 Stunden unter Rückfluss erhitzt. Es bildet sich langsam ein weißer pulvriger Niederschlag. Der Niederschlag wird durch Filtration gesammelt, mit Diethylether gewaschen und über Silicagel unter reduziertem Druck getrocknet. Das erhaltene weiße Material wird durch Umkristallisation aus Dichlorethan/Diethylether gereinigt und mit einer Ausbeute von 0,92 g (43 %) erhalten.

| Elementaranalyse: | |
|---|---|
| C | 55,42, |
| H | 3,49, |
| N | 4,04; |

| gefunden: | |
|---|---|
| C | 55,06, |
| H | 3,60, |
| N | 3,94. |

### b) [Pt(binap)(CN)₂] x H₂O

Eine Mischung von Pt(CN)₂ (0,25g, 1 mmol) und binap (0,63 g, 1 mmol) in 40 ml Dimethylformamid wird für 20 Stunden unter Rückfluss erhitzt. Nach Filtration der Mischung wird Diethylether zu der erhaltenen Lösung hinzu gegeben. Dabei fällt ein leicht gelbes Pulver aus. Das gelbe Pulver wird durch Filtration gesammelt, mit Diethylether gewaschen und über Silicagel bei vermindertem Druck getrocknet. Das erhaltene leicht gelbe Material wird aus Dichlormethan/Diethylether umkristallisiert, wobei 0,58 g (65 %) des gewünschten Produktes erhalten werden.

| Elementaranalyse: | |
|---|---|
| C | 62,23, |
| H | 3,86, |
| N | 3,16; |

| gefunden: | |
|---|---|
| C | 62,68, |
| H | 3,90, |
| N | 3,07. |

### c) [Pt(bathophen)(CN)₂x H₂O]

Die Herstellung von [Pt(bathophen)(CN)₂ x H₂O] ist in J. Am. Chem. Soc. 112 (1990) 5625 - 5627 offenbart.

### d) [Pt(4,4'-Bu₂bpy)(CN)₂]*

0.99 g (4.0 mmol) Pt(CN)₂ und 1.10 g (4.0 mmol) 4,4'-Di-tert.-butyl-2,2'-dipyridyl (4,4'-Bu₂bpy) wurden in 70 ml DMF 84 h lang unter Rückfluss erhitzt. Es resultierte eine schwach gelbe Lösung mit grünlichem Niederschlag. Dieser wurde abfiltriert und das Filtrat mit Diethylether versetzt. Es fiel ein feiner schwach gelber Niederschlag aus, der abgesaugt, mit Diethylether gewaschen und über Silicagel getrocknet wurde. Ausbeute: 0.94 g (46 % d. Th.). Die erhaltene Substanz wurde aus DMF/Diethylether umkristallisiert.
C₂₀H₂₄N₄Pt (515.53): Ber. C 46.76, H 4.69, N 10.87; Gef. C 45.34, H 4.54, N 11.18. MS(ESI): 515 (77 %), 516 (MH⁺, 100 %), 517 (82 %)
- Die Herstellung erfolgte analog zu [Pt(CN)₂(5,5'-Me₂bpy)] in Che, C.-M., Wan, K.-T., He, L.-Y., Poon, C.-K., Yam, V.W.-W., J. Chem. Soc., Chem. Commun. 1989, 943.

## Patentansprüche

1. Verwendung von neutralen Platin(II)-Komplexen ausgewählt aus der Gruppe bestehend aus
Platin(II)-Phosphinkomplexen der Formel (I) 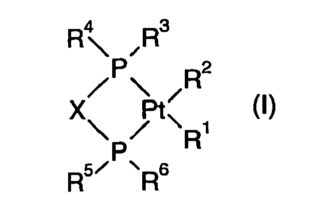 Platin(II)-Bathophen-Komplexen der Formel (II) 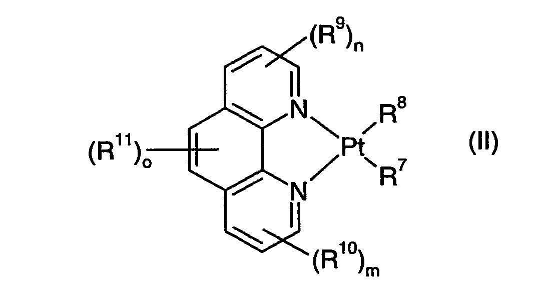 und
Platin(II)-Bipyridyl-Komplexen der Formel (II) 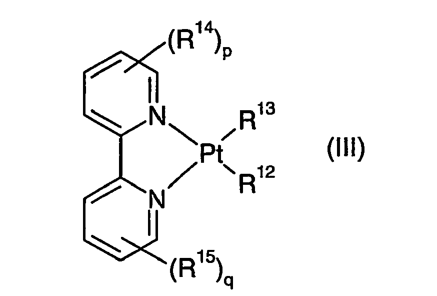 worin die Symbole die folgenden Bedeutungen aufweisen:
R¹, R², R⁷, R⁸, R¹², R¹³ unabhängig voneinander CN, Acetylid, Thiocyanat oder Isocyanat;
R³, R⁴, R⁵, R⁶, R⁹, R¹⁰, R¹⁴, R¹⁵ unabhängig voneinander eine Aryl-, Alkyl-, Heteroaryl- oder Alkenylgruppe,
X eine Arylengruppe oder eine Heteroarylengruppe,
o 0 bis 2,
p, q unabhängig voneinander 0 bis 4,
n, m unabhängig voneinander 0 bis 3;
als Emittermoleküle in organischen Licht-emittierenden Dioden.

2. Verwendung nach Anspruch 1, **dadurch gekennzeichnet, dass** in den Platin(II)-Phosphinkomplexen der Formel I R¹ und R² CN oder Acetylid, bevorzugt CN, und R³, R⁴, R⁵ und R⁶ einen Arylrest, bevorzugt unsubstituiertes Phenyl bedeuten, und X ausgewählt ist aus der Gruppe bestehend aus einer Phenylengruppe, die in der 1- und 2-Position mit jeweils einem der beiden P-Atome der Formel I verknüpft ist, und besonders bevorzugt unsubstituiert ist, einer Naphthalindiylgruppe, die in 2- und 3-Position oder 4- und 5-Position mit jeweils einem der beiden P-Atome der Formel I verknüpft ist und besonders bevorzugt unsubstituiert ist, einer Phenanthrendiylgruppe, die in der 2- und 3-Position oder in der 4- und 5-Position mit jeweils einem der beiden P-Atome der Formel I verknüpft ist und besonders bevorzugt unsubstituiert ist, einer 1,1'-Biphenylengruppe, die in der 2-und 2'-Position mit jeweils einem der beiden P-Atome der Formel I verknüpft ist, und besonders bevorzugt unsubstituiert ist, einer 1,1'-Binaphthylengruppe, die in der 2- und 2'-Position mit jeweils einem der beiden P-Atome der Formel I verknüpft ist, und besonders bevorzugt unsubstituiert ist, besonders bevorzugt ist X ausgewählt aus einer Phenylengruppe, die in 1- und 2-Position mit jeweils einem der beiden P-Atome der Formel I verknüpft ist und unsubstituiert ist, und einer 1,1'-Binaphthylengruppe, die in 2- und 2'-Position mit jeweils einem der beiden P-Atome der Formel I verknüpft ist, und unsubstituiert ist.

3. Verwendung nach Anspruch 1, **dadurch gekennzeichnet, dass** in den Platin(II)-Komplexen der Formel II und den Platin(II)-Komplexen der Formel III R⁷, R⁸, R¹² und R¹³ CN, m, n, p, q 0 oder 1 und o 0 bedeuten, und - wenn m, n = 1 bedeuten - R⁹ und R¹⁰ unsubstituiertes Phenyl bedeuten und - wenn p, q 1 bedeuten - R¹⁴ und R¹⁵ tert-Bu bedeuten.

4. Verwendung nach einem der Ansprüche 1 bis 3, **dadurch gekennzeichnet, dass** die Platin(II)-Komplexe einkernige Komplexe sind.

5. Verwendung von Platin(II)-Komplexen gemäß einem der Ansprüche 1 bis 4 als Licht-emittierende Schicht in OLEDs.

6. Licht-emittierende Schicht enthaltend mindestens einen Platin(II)-Komplex gemäß einem der Ansprüche 1 bis 4 als Emittermolekül.

7. Licht-emittierende Schicht bestehend aus mindestens einem Platin(II)-Komplex gemäß einem der Ansprüche 1 bis 4 als Emittermolekül.

8. OLED enthaltend eine Licht-emittierende Schicht gemäß Anspruch 6 oder 7.

9. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Fahrzeugen sowie Zielanzeigen an Bussen und Bahnen enthaltend ein OLED gemäß Anspruch 8.

## Claims

1. The use of uncharged platinum(II) complexes selected from the group consisting of
platinum(II)-phosphine complexes of the formula (I), 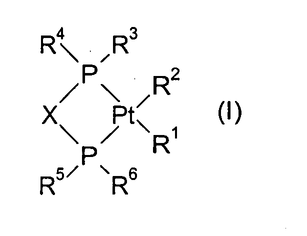 platinum(II)-bathophen complexes of the formula (II) 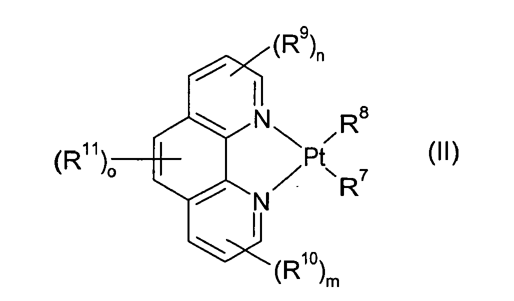 and
platinum(II)-bipyridyl complexes of the formula (III) 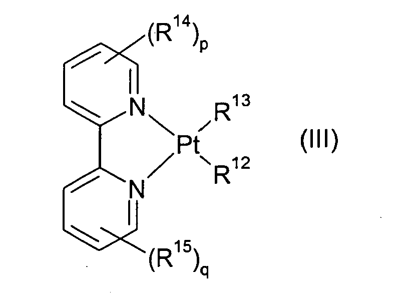 where the symbols have the following meanings:
R¹, R², R⁷, R⁸, R¹², R¹³ are each, independently of one another, CN, acetylide, thiocyanate or isocyanate;
R³, R⁴, R⁵, R⁶, R⁹, R¹⁰, R¹⁴, R¹⁵ are each, independently of one another, an aryl, alkyl, heteroaryl or alkenyl group;
X is an arylene group or a heteroarylene group;
o is from 0 to 2;
p, q are each, independently of one another, from 0 to 4;
n, m are each, independently of one another, from 0 to 3;
as emitter molecules in organic light-emitting diodes.

2. The use according to claim 1, wherein, in the platinum(II)-phosphine complexes of the formula I, R¹ and R² are each CN or acetylide, preferably CN, and R³, R⁴, R⁵ and R⁶ are each an aryl radical, preferably unsubstituted phenyl, and X is selected from the group consisting of a phenylene group which is linked in the 1 and 2 positions to, in each case, one of the two P atoms in the formula I and is particularly preferably unsubstituted, a naphthalenediyl group which is linked in the 2 and 3 positions or 4 and 5 positions to, in each case, one of the two P atoms in the formula I and is particularly preferably unsubstituted, a phenanthrenediyl group which is linked in the 2 and 3 positions or in the 4 and 5 positions to, in each case, one of the two P atoms in the formula I and is particularly preferably unsubstituted, a 1,1'-biphenylene group which is linked in the 2 and 2' positions to, in each case, one of the two P atoms in the formula I and is particularly preferably unsubstituted, a 1,1'-binaphthylene group which is linked in the 2 and 2' positions to, in each case, one of the two P atoms in the formula I and is particularly preferably unsubstituted, and X is particularly preferably selected from among a phenylene group which is linked in the 1 and 2 positions to, in each case, one of the two P atoms in the formula I and is unsubstituted and a 1,1'-binaphthylene group which is linked in the 2 and 2' positions to, in each case, one of the two P atoms in the formula I and is unsubstituted.

3. The use according to claim 1, wherein, in the platinum(II) complexes of the formula II and the platinum(II) complexes of the formula III, R⁷, R⁸, R¹² and R¹³ are each CN, m, n, p, q are each 0 or 1 and o is 0, and, when m, n = 1, R⁹ and R¹⁰ are each unsubstituted phenyl and, when p, q = 1, R¹⁴ and R¹⁵ are each tert-Bu.

4. The use according to any of claims 1 to 3, wherein the platinum(II) complexes are mononuclear complexes.

5. The use of platinum(II) complexes according to any of claims 1 to 4 as light-emitting layer in OLEDs.

6. A light-emitting layer comprising at least one platinum(II) complex according to any of claims 1 to 4 as emitter molecule.

7. A light-emitting layer consisting of at least one platinum(II) complex according to any of claims 1 to 4 as emitter molecule.

8. An OLED comprising a light-emitting layer according to claim 6 or 7.

9. A device selected from the group consisting of stationary VDUs such as VDUs of computers, televisions, VDUs in printers, kitchen appliances and advertising placards, lighting, information signs and mobile VDUs such as VDUs in mobile telephones, laptops, vehicles and destination displays in buses and trains comprising an OLED according to claim 8.

## Revendications

1. Utilisation de complexes platineux neutres, sélectionnés dans le groupe constitué de complexes de phosphine platineux selon la formule (I) 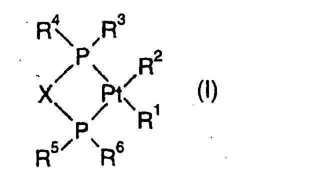 complexes de bathophène platineux selon la formule (II) 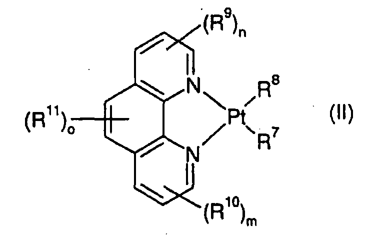 et de
complexes de bipyridyle platineux selon la formule (III) 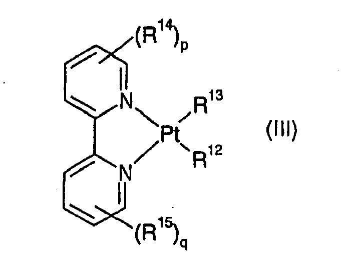 dans lesquelles les symboles ont les significations suivantes :
R¹, R², R⁷, R⁸, R¹², R¹³ indépendamment les uns des autres : CN, acétylide, thiocyanate ou isocyanate ;
R³, R⁴, R⁵, R⁶, R⁹, R¹⁰, R¹⁴, R¹⁵ indépendamment les uns des autres: un groupe aryle, alkyle, hétéroaryle ou alcényle,
X un groupe arylène ou un groupe hétéroarylène,
o 0 à 2,
p, q indépendamment l'un de l'autre 0 à 4,
n, m indépendamment l'un de l'autre 0 à 3 ;
en tant que molécules d'émetteur dans des diodes électroluminescentes organiques.

2. Utilisation selon la revendication 1, **caractérisée en ce que** dans les complexes de phosphine platineux de la formule I, R¹ et R² représentent CN ou un acétylide, préférentiellement CN, et R³, R⁴, R⁵ et R⁶ représentent un radical aryle, préférentiellement un phényle non substitué, et X est sélectionné dans le groupe constitué d'un groupe phénylène, qui dans les positions 1 et 2, est chaque fois relié avec l'un des deux atomes P de la formule I et est, de manière particulièrement préférentielle, non substitué, d'un groupe naphtalinediyle, qui dans les positions 2 et 3 ou les positions 4 et 5, est chaque fois relié avec l'un des deux atomes P de la formule I et est, de manière particulièrement préférentielle, non substitué, d'un groupe phénanthrènediyle, qui dans les positions 2 et 3 ou dans les positions 4 et 5, est chaque fois relié avec l'un des deux atomes P de la formule I et est, de manière particulièrement préférentielle, non substitué, d'un groupe 1,1'-biphénylène, qui dans les positions 2 et 2', est chaque fois relié avec l'un des deux atomes P de la formule I, et, de manière particulièrement préférentielle, est non substitué, d'un groupe 1,1'-binaphtylène, qui, dans les positions 2 et 2', est chaque fois relié avec l'un des deux atomes P de la formule I, et, de manière particulièrement préférentielle, est non substitué, de manière particulièrement préférentielle X est sélectionné à partir d'un groupe phénylène, qui, dans les positions 1 et 2, est chaque fois relié avec l'un des deux atomes P de la formule I et est non substitué, et d'un groupe 1,1'-binaphtylène, qui, dans les positions 2 et 2', est chaque fois relié avec l'un des deux atomes P de la formule I et est non substitué.

3. Utilisation selon la revendication 1, **caractérisée en ce que** dans les complexes platineux de la formule II et les complexes platineux de la formule III, R⁷, R⁸, R¹² et R¹³ désignent CN, m, n, p, q 0 ou 1 et o 0, et - si m, n = 1 - R⁹ et R¹⁰ désignent un phényle non substitué et - si p, q = 1 - R¹⁴ et R¹⁵ désignent tert-Bu.

4. Utilisation selon l'une des revendications 1 à 3, **caractérisée en ce que** les complexes platineux sont des complexes mononucléiques.

5. Utilisation de complexes platineux selon l'une des revendications 1 à 4 en tant que couche électroluminescente dans des diodes OLED.

6. Couche électroluminescente comportant au moins un complexe platineux selon l'une des revendications 1 à 4 en tant que molécule d'émetteur.

7. Couche électroluminescente constituée d'au moins un complexe platineux selon l'une des revendications 1 à 4 en tant que molécule d'émetteur.

8. Diode OLED contenant une couche électroluminescente selon la revendication 6 ou 7.

9. Dispositif sélectionné à partir du groupe comprenant des écrans fixes comme des écrans d'ordinateurs, de téléviseurs, des écrans dans des imprimantes, des appareils ménagers, de même que des panneaux publicitaires, des éclairages, des panneaux indicateurs et écrans mobiles comme les écrans de téléphones portables, de portables, de véhicules, de même que des indications de destination sur des autobus et des tramways comportant une diode OLED selon la revendication 8.
